# EUROPÄISCHE PATENTSCHRIFT

(11) **EP 1 741 184 B1**
(45) Veröffentlichungstag und Bekanntmachung des Hinweises auf die Patenterteilung: **18.11.2009**
(21) Anmeldenummer: 05731905.5
(22) Anmeldetag: 12.04.2005
(51) Int. Cl.: H03K 3/537

(54) **VERWENDUNG EINES HOCHSPANNUNGSKABELS ALS HOCHSPANNUNGS-ENTKOPPLUNG BEI EINEM MARX-GENERATOR**
USE OF A HIGH-VOLTAGE CABLE AS HIGH VOLTAGE DECOUPLING IN A MARX-GENERATOR
UTILISATION D'UN CABLE HAUTE TENSION EN TANT QUE DECOUPLAGE HAUTE TENSION DANS UN GENERATEUR DE MARX

(30) Priorität: 26.04.2004 DE 102004020342
(43) Veröffentlichungstag der Anmeldung: 10.01.2007
(73) Patentinhaber: Diehl BGT Defence GmbH & Co.KG, 88662 Überlingen (DE)
(72) Erfinder: STAINES, Geoffrey, San Diego, CA 92111 (US)
(74) Vertreter: Diehl Patentabteilung
(86) Internationale Anmeldenummer: PCT/EP2005/003797
(87) Internationale Veröffentlichungsnummer: WO 2005/104367

(56) Entgegenhaltungen:
- KRONJAEGER J.: "Marx generator" JOCHEN'S HIGH VOLTAGE PAGE, [Online] 13. Juni 2003 (2003-06-13), XP002341356 Gefunden im Internet: URL:http://web.archive.org/web/20030613010 656/http://kronjaeger.com/hv/hv/src/marx/i ndex.html> [gefunden am 2005-08-19]
- RASMUSSEN C N ET AL: "TEST OF POLYMERS FOR HIGH VOLTAGE DC CABLES" INTERNATIONAL CONFERENCE ON POWER CABLES AND ACCESSORIES, IEE, XX, Juni 2003 (2003-06), Seiten 771-776, XP008051105

## Beschreibung

Die Erfindung betrifft die Verwendung eines Hochspannungskabels als ladeseitige Hochspannungs-Entkopplung bei einem Marx-Generator. Ein Schaltbild eines Marx-Generators ist aus folgender Internet-Adresse bekannt: web.archive.org/web/20030613010656/kronjaeger.com/hv/hv/src/marx/index.html

Der 1923 von Herm Prof. Marx (TU Braunschweig) erfundene Stoßspannungsgenerator dient der Bereitstellung eines Hochspannungsimpulses etwa für Zwecke der Isolationsprüfung, der Untersuchung des Verhaltens von Gasen in starken elektrischen Feldern oder gemäß DE 101 51 565 A1 der Anregung eines Resonators zur Abstrahlung von Mikrowellenenergie hoher Leistung.

Die grundsätzliche Funktion des Marx-Generators beruht darauf, eine Anzahl n (n = 1, 2, 3, ..., i) von zueinander parallel geschalteten Kondensatoren auf eine von einer Gleichspannungsquelle gelieferte Eingangsspannung aufzuladen und dann in Serie zu schalten, so dass über diese Serienschaltung die n-fache Eingangsspannung als Ausgangsspannung verfügbar ist. Dabei erfolgt das Umsteuern von der Parallelschaltung in die Serienschaltung der Kondensatorbatterie mittels Funkenstrecken, die bei Ansprechen einer ersten von ihnen alle praktisch gleichzeitig durchzünden. Das Ansprechen einer ersten Funkenstrecke kann mittels deren Ansprechspannung, also über die Querschnittsgeometrie und den gegenseitigen Abstand der Funkenstreckenelektroden vorgegeben werden; oder das Ansprechen einer ersten der Funkenstrecken wird durch einen ihr extern zugeführten Triggerimpuls eingeleitet. Entkopplungswiderstände, die auch als die Zeitkonstanten bestimmende Ladewiderstände wirken, verhindern, dass einer der beiden Kondensatoren, zwischen denen eine Funkenstrecke zur Serienschaltung liegt, infolge des Durchzündens der Funkenstrecke kurzgeschlossen wird. Dadurch wirkt die Reihenschaltung der Lade- und Entkopplungswiderstände beim Umschalten der Kondensatorbatterie auf Serienschaltung als Hochspannungs-Spannungsteiler; und dann liegen sowohl die eingangseitige Spannungsquelle des Marx-Generators wie auch dessen ausgangsseitige Ableitung gegenüber dem gemeinsamen Massepotential auf Hochspannungspotential.

Als Spannungsquelle des Marx-Generators dient gewöhnlich ein handelsüblicher elektronischer Spannungswandler, der aus einem Netz oder aus einem Akkumulator gespeist wird und die Parallelschaltung der Kondensatorbatterie auf eine Spannung von typisch einigen 10 kV auflädt Funktional kritisch ist dann die Hochspannungs-Rückwirkung auf die elektronische Schaltung dieser eingangsseitigen Spannungsquelle beim Umschalten von der Parallelschaltung auf die Serienschaltung der Kondensatorbatterie. Die kann zur Beeinträchtigung der Funktion der spannungsquelle oder gar zu deren Zerstörung führen, so dass ein stabiler Langzeit-Betrieb des Marx-Generators, etwa zur Dauer-Anregung eines Mikrowellen-Resonators, nicht möglich ist. Wegen der hohen Spannungsbeanspruchung sind gängige Filtermethoden hier, zwischen Spannungsquelle und Kondensatorbatterie des Marx-Generators, nicht einsetzbar, und die Verwendung spezieller Hochspannungswiderstände zur Entkopplung wäre zu kostspielig.

In Erkenntnis dieser Gegebenheiten liegt vorliegender Erfindung die technische Problemstellung zugrunde, den Marx-Generator eingangsseitig mit einfach und preiswert verfügbaren Mitteln hochspannungsfest auszulegen.

Diese Aufgabe ist erfindungsgemäß durch die im Hauptanspruch angegebene Merkmalskombination gelöst. Der Erfindung liegt dabei die Überlegung zugrunde, zwischen der Kondensatorbatterie und der Spannungsquelle eine elektrische Entkopplung in Form einer dielektrischen Leitung mäßig guter Leitfähigkeit vorzusehen. Unter einem Dielektrikum wird dabei jedes Material verstanden, welches gegenüber einem elektrischen Leiter eine verringerte Leitfähigkeit und damit auch gewisse Isolationseigenschaften aufweist. Die dielektrische Leitung, oder auch das dielektrische Kabel, kann aus einer dielektrischen Einlage und deren Ummantelung gebildet sein. Die Ummantelung kann dabei aus einer einzelnen schicht, wie etwa einer Stossschutzschicht, einer Isolationsschicht, einer abriebfesten Schicht, etc. oder mehrerer derartiger Schichten gebildet sein. Eine solche Leitung steht erfindungsgemäß durch Verwendung handelsüblicher und deshalb preiswerter Hochspannungskabel mit dielektrischer Einlage zur Verfügung, wenn daraus die eigentliche Leiterseele entfernt wird; so dass im Isoliermantel oder der Ummantelung nur der Schlauch aus halbleitendem Material, also die dielektrische Einlage, verbleibt, der eigentlich die Leiterseele umgibt und dafür vorgesehen ist, einen in Hinblick auf zerstörerische Koronaeffekte im Innern des Kabels kritischen Potentialsprung zwischen Leiterseele und Isolierung zu vermeiden.

Die dielektrische Einlage des dielektrischen Hochspannungskabels weist einen typischen elektrischen Widerstand von ca. 50 bis 200 Ohm/cm Länge der dielektrischen Einlage im Kabel auf. Das ohne Leiterseele, nur noch mit dem Halbleiterstrang ausgestattete Hochspannungskabel weist typisch einen bevorzugten elektrischen Widerstand von etwa 100 Ohm je cm Länge der Halbleitereinlage im Kabel auf. Dieser Übergangswidertand von der Spannungsquelle zur Kondensatorbatterie führt nicht zu funktionskritischen Spannungsverlusten, weil die Aufladung der Kondensator-Parallelschaltung typisch mit einem Ladestrom in der Größenordnung von nur bis etwa 10 mA erfolgt. Wenn dann von der umgeschalteten Kondensatorbatterie her vorübergehend, impulsartig Hochspannung an der dielektrischen Entkopplungsleitung anliegt, führt das wegen der hier nun wirksamen Zeitkonstanten als dem Produkt aus Halbleiterwiderstand und parasitären Kapazitäten noch nicht zu funktlonskritischen Einwirkungen auf die Elektronik im Spannungswandler.

Für die praktische Realisierung wird also auch eingangsseitig auf ein dielektrisches Kabel, insbesondere auf ein handelsübliches Hochspannungskabel zurückgegriffen, wie es als Ableitung ausgangsseitig am Marx-Generator zum Anschluss an etwa einen Mikrowellen-Resonator eingesetzt wird; aber für die eingangsseitige Verwendung des Hochspannungskabels als Hochspannungs-Entkopplung wird die an sich stromleitende (Kupfer-)Kabelseele aus ihrer halbleitenden Einhüllung im Isolierstoffmantel des Hochspannungskabels herausgezogen, so dass das Hochspannungskabel hier im Isolierstoffmantel nur noch über das halbleitende Material als dielektrischen Widerstand zwischen der Spannungsquelle und der Kondensatorbaüerie des Marx-Generators verfügt.

## Patentansprüche

1. Verwendung eines zwischen die Kondensatorbatterie eines Marx-Generators und seine Lade-Spannungsquelle geschalteten Hochspannungskabels mit dielektrischer Einlage als Hochspannungsentkopplung zwischen der Batterie und der Spannungsquelle,
**dadurch gekennzeichnet,**
**dass** das Hochspannungskabel ein handelsübliches Kabel mit dielektrischer Einlage ist, aus dem die von der dielektrischen Einlage eingehüllte Kabelseele herausgezogen wurde.

## Claims

1. Use of a high-voltage cable, which is connected between the capacitor battery of a Marx generator and the charging voltage source thereof, with dielectric liner as high-voltage decoupling between the battery and the voltage source, **characterized in that** the high-voltage cable is a conventional cable with dielectric liner from which the cable core, enveloped by the dielectric liner, has been withdrawn.

## Revendications

1. Utilisation d'un câble haute tension monté entre la batterie de condensateur d'un générateur de Marx et sa source de tension de charge, avec une gaine diélectrique servant de découplage de haute tension entre la batterie et la source de tension, **caractérisée en ce que** le câble haute tension est un câble usuel dans le commerce, avec une gaine diélectrique, de laquelle est tirée l'âme du câble enveloppée par la gaine diélectrique.
